# EUROPÄISCHE PATENTANMELDUNG

(11) **EP 1 283 554 A2**
(43) Veröffentlichungstag der Anmeldung: **12.02.2003**
(21) Anmeldenummer: 02102095.3
(22) Anmeldetag: 05.08.2002
(51) Int. Cl.: H01L 51/20

(54) **Organische elektrolumineszente Anzeigevorrichtung mit Schutzschicht**

(30) Priorität: 06.08.2001 DE 10137712
(71) Anmelder: Philips Corporate Intellectual Property GmbH, 20099 Hamburg (DE); Koninklijke Philips Electronics N.V., 5621 BA Eindhoven (NL)
(72) Erfinder: Bachmann, Peter Klaus, Postfach 500442, 52088, Aachen (DE); van Elsbergen, Volker, Postfach 500442, 52088, Aachen (DE)
(74) Vertreter: Volmer, Georg, Dipl.-Ing.

(57) **Zusammenfassung**

Die Erfindung betrifft eine organische elektrolumineszente Anzeigevorrichtung, die eine Frontelektrodenkomponente, ein Gegenelektrodenkomponente, eine organische elektrolumineszente Komponente zwischen der Frontelektrodenkomponente und der Gegenelektrodenkomponente und eine Schutzschicht aus einer amorphen Kohlenstoffmodifikation, die eine gas- und feuchtigkeitsdichte Versiegelung für die organische elektrolumineszente Anzeigevorrichtung darstellt, umfasst.

Die Erfindung betrifft auch ein Verfahren zur Herstellung einer derartigen Anzeigevorrichtung.

## Beschreibung

Die Erfindung betrifft eine organische elektrolumineszente Anzeigevorrichtung (OLED), die eine Frontelektrodenkomponente (member), eine Gegenelektrodenkomponente, eine organische elektrolumineszente Komponente(member) zwischen der Frontelektrodenkomponente und der Gegenelektrodenkomponente und eine Schutzschicht aus einem anorganischen Sperrschichtmaterial umfasst.

LEDs nach dem Stand der Technik sind in der Regel anorganische Halbleiterdioden, d.h. Dioden, deren Emittermaterial ein anorganischer Halbleiter, z. B. ZnS, Silicium, Germanium oder eine III-V-Halbleiter wie InP, GaAs, GaAlAs, GaP oder GaN mit entsprechenden Dotierungen ist.

Mit der Verfügbarkeit halbleitender organischer konjugierter Polymere und dem Nachweis ihrer Eignung zur Herstellung von lichtemittierenden Bauelementen begannen weltweit umfangreiche Arbeiten zur Entwicklung von organischen Elektrolumineszenzdioden und darauf aufbauend auch zu Displays. Im Gegensatz zu den anorganischen LEDs, deren Verwendung in höher auflösenden Displays nur bedingt und mit hohen Kosten möglich ist, wird in organischen Elektrolumineszenzdioden ein gewaltiges Potential für kleine und handliche Displays gesehen.

Organische Elektrolumineszenzdisplays haben im Gegensatz zu Flüssigkristalldisplays auch den Vorteil, dass sie selbstleuchtend sind und daher keine zusätzliche rückwärtige Beleuchtungsquelle benötigen.

Sie finden daher Anwendung, wo selbstleuchtende Anzeigevorrichtungen mit niedriger Versorgungsspannung und geringer Verlustleistung gefragt sind Dazu zählen vor allem Displays für den mobilen Einsatz wie Handys, Organizer oder Anwendungen im Auto - vom Radio bis zum Navigationssystem.

Ein ernsthaftes Problem ist jedoch noch die zu kurze Lebensdauer der organischen elektrolumineszenten Anzeigevorrichtungen. Insbesondere ist es ein Nachteil, dass die Luminanz der Anzeigevorrichtungen während des Betriebes ungleichmäßig verteilt über die Oberfläche abnimmt. Es treten - auch wenn die Anzeigevorrichtung nicht in Betrieb ist - mit der Zeit dunkle Flecken in der elektrolumineszierenden Schicht auf. Diese dunklen Recken werden verursacht und in ihrer Ausbreitung begünstigt durch Feuchtigkeit und schädliche Gase aus der umgebenden Atmosphäre.

Um organische elektrolumineszente Anzeigevorrichtungen gegen Feuchtigkeit und schädliche Gase abzudichten, wurden bereits verschiedenen Anordnungen mit gasdichten Gehäuse oder feuchtigkeitsabsorbierenden Mitteln in dem Gehäuse vorgeschlagen.

Beispielsweise beschreibt US 6160346 eine elektrolumineszente Vorrichtung, die ein elektrolumineszentes Bauteil umfasst, das eine elektrolumineszente organische Schicht und zwei Elektroden in Kontakt mit der elektrolumineszenten Schicht umfasst, wobei das elektrolumineszente Bauteil in einem Gehäuse eingeschlossen ist, das aus anorganischen Sperrschichtmaterialien besteht, die ein niedrig schmelzendes Metall oder eine niedrig schmelzende Legierung mit einem Schmelzpunkt unterhalb etwa 250°C umfassen Das Gehäuse bildet eine luftdichte und wasserdichte Versiegelung für das elektrolumineszente Bauteil.

Nachteilig an dieser elektrolumineszenten Vorrichtung ist es, dass sie gegenüber mechanischen Beschädigungen des Gehäuses mit einer plastischen Verformung reagiert.

Es ist eine Aufgabe der vorliegenden Erfindung, eine organische elektrolumineszente Vorrichtung mit einer mechanisch und chemisch stabilen Schutzschicht zur Verfügung zu stellen, die als zuverlässige Diffusionsbarriere gegen Feuchtigkeit wirkt.

Erfindungsgemäß wird die Aufgabe gelöst durch eine organische elektrolumineszente Anzeigevorrichtung, die eine Frontelektrodenkomponente, ein Gegenelektrodenkomponente, eine organische elektrolumineszente Komponente zwischen der Frontelektrodenkomponente und der Gegenelektrodenkomponente und eine Schutzschicht aus einer amorphen Kohlenstoffmodifikation umfasst.

Diese Schutzschicht bildet eine zusammenhängende Materieschicht und wirkt wie eine hermetische Verpackung, durch die die Anzeigevorrichtung vor Umwelteinflüssen, wie Feuchtigkeit und mechanischen Belastungen geschützt wird.

Sie hat eine hervorragende Sperrwirkung gegen das Eindringen von Wasserdampf und anderen kontaminierenden bzw. korrodierenden Stoffe und ist unempfindlich gegen mechanische Verformung, Rissbildung und Kratzer.

Es ist bevorzugt, dass der spezifische elektrische Widerstand der Schutzschicht ρ≥ 10⁶ Ω cm beträgt.

Es ist auch bevorzugt, dass die Schichtdicke der Schutzschicht d ≤ 5 µm ist. Bei einigen Anwendungen können bereits Schichtdicken von 50 nm einen ausreichen Schutz bieten.

Die Erfindung betrifft auch eine Verfahren zur Herstellung einer organischen elektrolumineszenten Anzeigevorrichtung, die eine Frontelektrodenkomponente, eine Gegenelektrodenkomponente, eine organische elektrolumineszente Komponente zwischen der Frontelektrodenkomponente und der Gegenelektrodenkomponente und eine Schutzschicht aus einer amorphen Kohlenstoffmodifikation, bei dem die Schutzschicht aus der Gasphase abgeschieden wird.

Nach einer bevorzugten Ausführungsform der Erfindung wird die Schutzschicht durch ein Mikrowellen-Plasma-CVD-Verfahren abgeschieden.

Besonders bevorzugt ist es, dass der Arbeitspunkt der Abscheidung aus der Gasphase im kinetisch kontrollierten Bereich liegt.

Nachfolgend wird die Erfindung anhand einer Figur weiter erläutert.

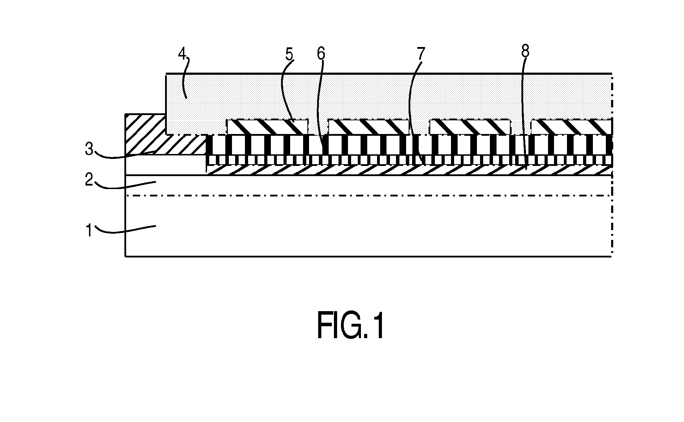

- Fig. 1: zeigt den schematischen Aufbau einer organischen elektrolumineszenten Anzeigevorrichtung nach der Erfindung.

Eine organische elektrolumineszentes Anzeigevorrichtung nach der Erfindung umfasst eine Frontelektrodenkomponente, ein Gegenelektrodenkomponente, eine organische elektrolumineszente Komponente zwischen der Frontelektrodenkomponente und der Gegenelektrodenkomponente und eine Schutzschicht aus einer amorphen Kohlenstoffmodifikation.

Typischerweise besteht eine derartige Anzeigevorrichtung aus einem Schichtverbund von übereinander und teilweise nebeneinander aufgetragenen Einzelschichten. Für den Aufbau kommen alle dem Fachmann bekannten Schichtstrukturen und Materialien für diese Schichten in Frage. Üblicherweise enthalten die OLEDs eine elektrolumineszierende Schicht zwischen einer positiven Elektrode als Frontelektrode und einer negativen Elektrode als Gegenelektrode, wobei eine oder beide Elektroden transparent und/oder segmentiert sein können. Zusätzlich können zwischen der elektrolumineszierenden Schicht und der positiven Elektrode eine oder mehrere Elektroneninjektions- und/oder Elektronentransportschichten angeordnet werden. Ebenso können zwischen der elektrolumineszierenden Schicht und der negativen Elektrode eine oder mehrere Löcherinjektions- und/oder Löchertransportschichten angeordnet werden.

Fig 1 zeigt eine Ausführungsform der organische elektrolumineszente Anzeigevorrichtung mit einer Schutzschicht aus amorphem Kohlenstoff.

Sie umfasst eine erste Elektrode 8 aus ITO mit Kontaktanschlüssen 3, eine elektrolumineszente Schicht 7 aus PDOT, eine zweite elektrolumineszente Schicht 6 aus PPV und eine zweite Elektrode aus Al 5. Die organische elektrolumineszente Anzeigevorrichtung ist weiterhin von einer Schutzschicht aus amorphem Kohlenstoff 4 bedeckt. Die Anzeigevorrichtung kann vollständig von der Schutzschicht aus einer amorphen Kohlenstoffmodifikation bedeckt sein. Bevorzugt ist sie auf einem optisch transparenten Substrat 1 mittels einer haftungsvermittelnden Schicht aus SiO₂ 2 aufgsbracht.

Dieser Schichtverbund kann auf einem Substrat aus Glas, Quarz, Keramik, Kunstharz oder einer durchsichtigen, flexiblen Plastikfolie angeordnet sein. Geeignete Kunstharze sind z. B. Polyimide, Polyethylenterephtalate und Polytretrafluoroethylene.

Die elektrolumineszente Schicht ist zwischen zwei Elektrodenschichten angeordnet.

Die negative Elektrode liefert Elektronen, die sich mit den von der positiven Elektrode ausgehenden Löchern in der organischen elektrolumineszenten Schicht zu Excitonen vereinigen und bei der Rekombination Photonen ausstrahlen.

Wenigstens eine der Elektrodenschichten sollte transparent oder wenigstens transluzent sein. Üblicherweise ist die positive Elektrode aus einem nichtstöchiometrischem oder dotierten Zinnoxid, z.B. ITO, oder einem Metall mit hoher Austrittsarbeit, z. B. Gold oder Silber hergestellt. Diese Elektrodenmaterialien können leicht als transparente Schichten hergestellt werden. Besonders ITO ist geeignet, aufgrund der Tatsache, dass es gute elektrische Leitfähigkeit hat und transparent ist.

Ebenso kann eine Schicht aus einem leitfähigen Polyanilin oder Poly-3,4-ethylen dioxythiophen allein oder zusammen mit einer ITO-Schicht als transparente positive Elektrode verwendet werden.

Die negative Elektrode, die Elektronen in die organische elektrolumineszente Schicht injiziert, soll eine niedrige Austrittsarbeit haben. Geeignet als Material für die negative Elektrode sind z. B. Indium, Aluminium, Calcium, Barium oder Magnesium. Wenn die negative Elektrode aus dem reaktiven Barium gefertigt wird, empfiehlt es sich, diese Elektrodenschicht mit einer weiteren Schutzschicht aus einem Epoxyharz oder einem inerten Metall zu bedecken. Diese Schichten haben den Vorteil, dass sie nicht so stark reflektieren wie metallische Schichten.

Als organische elektrolumineszente Komponente für die Anwendung in organischen LEDs haben sick aromatische, konjugierte Leiterpolymere vom Poly(para-phenylen)-Typ (LPPPs), die chemisch den Oligo- oder Polyphenylen ähnlich sind, als besonders geeignet herausgestellt. LPPPs weisen eine durchgehende Kette von konjugierten Doppelbindungen auf. Besonders geeignet sind z. B. lösliche Polyphenylenethylenvinylene und lösliche Polythiophene, insbesondere Polyphenylvinylene, die am Phenylring in 2- und 5-Position weiter mit Alkyl- oder Alkoxy-Resten substituiert sind. Derartige Polymere sind leicht verarbeitbar und ergeben Schichten mit amorpher Struktur. Beispiele für geeignete Polyphenylenvinyle sind Poly(2-methyl-5-(n-dodecyl)-p-Phenylenvinylen, Poly(2-methyl-5-(3,5,dimethyloctyl)-p-Phenylenvinylen, Poly(2-methyl-5-(4,6,6,-trimethylheptyl)-p-Phenylenvinylen, Poly(2-methoxy-5-dodecyloxy-p-Phenylenvinylen und Poly(2-methoxy-5-(ethylhexyloxy)-p-Phenylenvinylen (MEH-PPV).

Deutlich besser als organische elektrolumineszente Anzeigevorrichtung mit einer einzigen Elektrolumineszenzschicht funktionieren Anzeigevorrichtungen, die zwei verschiedene Elektrolumineszenzschichten enthalten. Eine Schicht transportiert Löcher effektiv, z. B. PPV, eine Schicht transportiert Elektronen effektiv, z. B. Oxadiazol. Dadurch können nun Löcher und Elektronen leichter rekombinieren.

Besonders vorteilhaft für den Transport der positiven Ladungsträger ist Polyethylendioxythiophen PEDOT und Polyethylendioxythiophen-Polystyrensulfonat PEDOT-SS. Besonders vorteilhaft wird für den Transport der positiven Ladungsträger auch 4,4',4''-Tris[N-(1-naphtyl)-N--phenyl-amino]-triphenylamin zusammen mit Hydroxychinolin-Aluminium-III-Salz Alq₃ als Emissions- und Elektronentransportmaterial eingesetzt.

Derartige organische elektrolumineszente Anzeigevorrichtungen sind an sich bekannt.

Gemäß der Erfindung enthält die Anzeigevorrichtung eine Schutzschicht aus einer amorphen Kohlenstoffmodifikation. Die Schutzschicht weist eine gute Haftung zu den Metallen bzw. Legierungen der Elektroden auf und gleicht die relativ zerklüftete Oberfläche der organischen elektrolumineszenten Anzeigevorrichtung zu einer glatten, dichten Oberfläche aus.

Kohlenstoff in einer amorphen Modifikation ist eine Kohlenstoffmaterial, bei dem ein amorphes, nanokristallines oder mikrokristallines Kohlenstoffnetzwerk vorliegt. Derartige Kohlenstoffmodifikationen werden auch als a-C, a-C:H, t-aC oder wegen der großen mechanischen Härte als diamantartiger Kohlenstoff oder Glaskohlenstoff bezeichnet.

Diese amorphen Modifikationen von Kohlenstoff erhalten ihre besonderen Eigenschaften durch das Nebeneinander von tetraedrischer Bindung mit sp³-Hybridisierung und trigonaler Bindung mit sp²-Hybridisierung in ihrer Struktur.

Die Schutzschicht aus einer amorphen Modifikation von Kohlenstoff kann durch Abscheidung aus der Gasphase, d.h. durch ein PVD-Verfahren wie Sputtern und Verdampfen, insbesondere aber durch ein CVD-Verfahren hergestellt werden.

Die CVD-Verfahren, die geeignet sind, schließen die Plasma-CVD-, ECR-Plasma-CVD-, DC-Plasma-Jet-CVD-, Filtered Cathode Arc Deposition-, Cascaded-Arc-CVD-, RF-Plasma-CVD und Mikrowellen-Plasma-CVD-Verfahren ein.

Bevorzugt ist das Mikrowellen-Plasma-CVD-Verfahren, weil die Konformität der Abscheidung beim Mikrowellen-Plasma-CVD-Verfahren besonders hoch ist. Bei einer ideal konformen Abscheidung bildet sich die Schicht an vertikalen Strukturflächen mit der gleichen Rate wie an horizontalen Oberflächen und es wird eine gleichmäßige Stufenabdeckung erreicht. Eine konforme Abscheidung wird begünstigt, wenn der Arbeitspunkt der Abscheidung aus der Gasphase im kinetisch kontrollierten (reaktionsbegrenzten) Bereich liegt. Hohe Temperaturen begünstigen ebenfalls die konforme Abscheidung, jedoch ist es bevorzugt, dass die Abscheidetemperatur unter 250°C liegt. Da die Temperatur zur Pyrolyse nicht ausreicht, wird das Quellgas zusätzlich durch eine Hochfrequenz-Gasentladung angeregt: und zersetzt, so dass es an der Oberfläche der organischen elektrolumineszenten Anzeigevorrichtung haftet.

Die zu beschichtende Oberfläche wird bevorzugt während der Beschichtung relativ zur Kohlenstoffquelle bewegt.

Durch entsprechende Reaktionsführung können bei der Abscheidung aus der Gasphase Schichten aus amorphem Kohlenstoff mit hohem elektrischen Widerstand hergestellt werden. Schichten mit Widerständen bis 10¹³Ω cm sind möglich.

Die Schutzschicht kann bei der Abscheidung aus der Gasphase aus verschiedenen Quellgasen gebildet werden. Bevorzugt sind gasförmige Kohlenwasserstoffe, z. B. Alkane, d.h. gesättigte aliphatische Kohlenwasserstoffe wie Methan, Ethan und Propan. Bevorzugt wird Methan verwendet. Daneben können aber auch Alkene, d.h. ungssättigte Kohlenwasserstoffe, wie Ethen und Propen eingesetzt werden, sowie Acetylen, Cycloalkane, d.h. gesättigte cyclische Kohlenwasserstoffe, wie Cyclohexan und - im dampfförmigen Zustand- aromatische Kohlenwasserstoffe wie Benzol oder Benzolderivate. Die Kohlenwasserstoffe der vorstehend genannten Art können einzeln oder im Gemisch eingesetzt werden. Den Kohlenwasserstoffes können weiterhin Edelgase, wie Helium oder Argon, zugesetzt werden.

Die zu beschichtende Oberfläche der organischen elektrolumineszenten Anzeigevorrichtung wird vorteilhafterweise während des Beschichtungsverfahrens durch Maßnahmen, wie z.B. Strahlführung, Filter usw. gegen den Einfluss von beim Beschichtungsverfahren entstehende UV-Strahlung und Ionenbeschuss geschützt.

Die Anzeigevorrichtung nach der Erfindung kann weiterhin optische Filterkomponenten enthalten, die die Spiegelungen innerhalb der Anzeigevorrichtung unterdrücken. Diese Spiegelungen entstehen einerseits an den Grenzflächen zwischen den Schichten der Anzeigevorrichtung, die mit unterschiedliche Brechungsindizes haben, andererseits an der metallischen Kathode, die wie ein metallischer Spiegel wirkt.

Um die Lichtreflexion an der Kathode zu unterdrücken, kann die Kathode mit einer elektrisch leitenden und lichtabsorbierenden Schicht bedeckt werden.

Die erfindungsgemäße Anzeigevorrichtung kann zusätzliche, die elektro-optischen Eigenschaften beeinflussende Einrichtungen enthalten, wie UV-Filter, Anti-Reflexbeschichtungen, als Micro-Cavities bekannte Einrichtungen sowie Farbkonversions- und Farbkorrekturfilter.

Die Anzeigevorrichtung kann z.B. als segmentierte Anzeige oder als Matrix-Display mit separat adressierten Pixeln ausgebildet sein. Die einzelnen Bildpunkte sind allein durch die Form der Elektroden leicht darzustellen, da das Polymermaterial der organischen elektrolumineszenten Komponente einen hohen Widerstand besitzt. Die Diffusion der Ladungsträger ist daher minimal, was ein Übersprechen zwischen den Bildpunkten verhindert.

Die Anzeigevorrichtung wird durch einen Elektronikteil zu einem kompletten Bildschirm ergänzt.

## Patentansprüche

1. Organische elektrolumineszente Anzeigevorrichtung, die eine Frontelektrodenkomponente, ein Gegenelektrodenkomponente, eine organische elektrolumineszente Komponente zwischen der Frontelektrodenkomponente und der Gegenelektrodenkomponente und eine Schutzschicht aus einer amorphen Kohlenstoffmodifikation umfasst.

2. Organische elektrolumineszente Anzeigevorrichtung gemäß Anspruch 1,
**dadurch gekennzeichnet,**
**dass** der spezifische elektrische Widerstand der Schutzschicht ρ≥ 10⁶ Ω cm beträgt.

3. Organische elektrolumineszente Anzeigevorrichtung gemäß Anspruch 1,
**dadurch gekennzeichnet,**
**dass** die Schichtdicke der Schutzschicht d≤ 5 µm ist.

4. Verfahren zur Herstellung einer organischen elektrolumineszenten Anzeigevorrichtung, die eine Frontelektrodenkomponente, eine Gegenelektrodenkomponente, eine organische elektrolumineszente Komponente zwischen der Frontelektrodenkomponente und der Gegenelektrodenkomponente und eine Schutzschicht aus einer amorphen Kohlenstoffmodifikation, bei dem die Schutzschicht aus der Gasphase abgeschieden wird

5. Verfahren zur Herstellung einer organischen elektrolumineszenten Anzeigevorrichtung gemäß Anspruch 4,
**dadurch gekennzeichnet,**
**dass** die Schutzschicht durch ein Mikrowellen-Plasma-CVD-Verfahren abgeschieden wird

6. Verfahren zur Herstellung einer organischen elektrolumineszenten Anzeigevorrichtung gemäß Anspruch 4,
**dadurch gekennzeichnet,**
**dass** der Arbeitspunkt der Abscheidung aus der Gasphase im kinetisch kontrollierten Bereich liegt.
